# EUROPEAN PATENT APPLICATION

(11) **EP 4 299 647 A1**
(43) Date of publication of application: **03.01.2024**
(21) Application number: 22182266.1
(22) Date of filing: 30.06.2022
(51) Int. Cl.: C08G 61/12, C08L 65/00, C09D 165/00, H01L 51/00

(54) **METHOD FOR PRODUCING DOPED ORGANIC NANOPARTICLES, METHOD FOR PRODUCING A FUNCTIONAL LAYER, FUNCTIONAL LAYER, AND ORGANIC SEMICONDUCTOR DEVICE**

(71) Applicant: Friedrich-Alexander-Universität Erlangen-Nürnberg, 91054 Erlangen (DE)
(72) Inventor: XU, Junyi, Erlangen (DE); BRABEC, Christoph, Nürnberg (DE); HEUMÜLLER, Thomas, Erlangen (DE)
(74) Representative: Louis Pöhlau Lohrentz

(57) **Abstract**

The invention refers to a method for producing doped organic nanoparticles. The method comprises the following steps, in particular in the following order:
a) dissolving a semiconducting polymer in a solvent to form a solution,
b) adding a dopant with concentrations in the range of 1 to 25 wt%, preferably in the range of 5 to 15 wt%, more preferably in the range of 9 to 11 wt% to the solution,
c) receiving a pre-assembled structure formed by strong interactions between the polymer-chains induced by doping,
d) injecting the solution into an antisolvent, preferably into an alcohol based antisolvent,
e) receiving a precipitation of doped organic nanoparticles as a (colloidal) dispersion, wherein the doped organic nanoparticles are formed by the pre-assembled structure encapsulating the dopant.

Furthermore, the invention refers to a method for producing a functional layer for an organic semiconductor device, to a functional layer, and to an organic semiconductor device comprising the functional layer.

## Description

The invention refers to a method for producing doped organic nanoparticles. Furthermore, the invention refers to a method for producing a functional layer comprising doped organic nanoparticles. Moreover, the invention refers to a functional layer comprising doped organic nanoparticles and to an organic semiconductor device comprising the functional layer.

Since the initial discovery in 1977, conducting polymers are recognized as a class of organic materials with tunable electrical, optical properties and versatile synthesis approaches. These unique properties make conducting polymers attractive in fabrication of next-generation organic-based electronics, such as transistors, photovoltaics and light-emitting diodes.

According to the European Patent EP 0 686 662 B1, PEDOT:PSS (having the full name poly(3,4-ethylenedioxythiophene)-poly(styrene sulfonic acid)) is known as a prototype conducting polymer. PSS, a water soluble polyelectrolyte, works as a dopant and also as a counter ion to stabilize the system. The great advantage of PEDOT:PSS is that it can be compatible with solution-based printing techniques. However, PEDOT:PSS still faces many challenges associated with its inherent limitations. For examples, aqueous PEDOT:PSS is difficult to coat on a hydrophobic organic layer. Surfactants are used to improve its wettability, but sacrifice the device performance. In addition, the hygroscopicity and acidity of PEDOT:PSS are unfavorable for the device stability and lifetime. In some cases [e.g., organic photovoltaics with deep-lying highest occupied molecular orbital (HOMO)], the fermi level of PEDOT:PSS is not deep enough to help charge extraction.

Doping process is a powerful means to control the electrical properties of organic semiconductors. A diverse array of dopants has been used for p-type and n-type doping of organic semiconductors. However, doped organic semiconductor solutions are currently limited by the mutual solubility which would attack the integrity of the underlying organic layer in vertical solution processing.

Currently, most solution-processable hole transport materials do not match well with non-fullerene heterojunction organic solar cells (OSCs) with the inverted structure, which severely limits a scalable fabrication.

The invention is based on the objective technical problem of eliminating the disadvantages of the prior art. In particular, a facile and versatile method for producing a functional layer comprising conducting polymers is to be provided. Furthermore, a functional layer comprising conducting polymers and an organic semiconductor device comprising the functional layer shall be provided.

According to the invention, this problem is resolved by a method for producing doped organic nanoparticles according to the subject matter of claim 1, by a method for producing a functional layer comprising doped organic nanoparticles according to the subject matter of claim 2, by a functional layer according to the subject matter of claim 8, and by an organic semiconductor device according to the subject matter of claim 12. Advantageous embodiments of the invention are given in the respective dependent claims.

According to the invention, a method for producing doped organic nanoparticles is claimed. The method comprises the following steps, in particular in the following order:
a) dissolving a semiconducting polymer in a solvent to form a solution,
b) adding a dopant to the solution,
c) receiving a pre-assembled structure formed by strong interactions between the polymer-chains induced by doping,
d) injecting the solution into an antisolvent, preferably into an alcohol based antisolvent,
e) receiving a precipitation of doped organic nanoparticles as a dispersion, wherein the doped organic nanoparticles are formed by the pre-assembled structure encapsulating the dopant,
f) evaporating the solvent.

It is further possible that the method steps are carried out once or several times. In particular, method steps and sub-steps may be repeated. The preferred sequence of the method steps has at least the sequence of step a) - step b) - step c) - step d) - step e) - step f), whereby in particular further steps or sub-steps can be inserted between these steps.

The solution formed in step a) can also be called precursor solution.

In step b), the dopant is preferably added to the solution with concentrations in the range of 1 to 25 wt%, more preferably in the range of 5 to 15 wt%, most preferably in the range of 9 to 11 wt%. These dopant concentrations are supposed to be moderate concentrations.

In step e), the precipitation of doped organic nanoparticles is preferably received as a colloidal dispersion.

The preparation of the doped organic nanoparticles is preferably performed by a nanoprecipitation technique. By the injection of the solution, preferably chloroform-based solution, into the alcohol based antisolvent, a condition of high supersaturation is preferably realized. In consequence, rapid precipitation is preferably achieved. This preferably triggers nucleation and growth of the doped organic nanoparticles. The dopant is preferably encapsulated in the doped organic nanoparticles.

In particular, the doped organic nanoparticles contain polymer and dopant. The properties of the doped organic nanoparticles can be adjusted by using different types and/or amounts of dopants and/or different polymers. In particular, each polymer has different properties (conductivities, energy level, etc.). Thus, by varying the combination of dopant and polymer, the properties of doped organic nanoparticles can be adjusted. For example, the doping effect is preferably different between polymers with different structures and energy levels.

Preferably, the conductivity of the doped organic nanoparticles is adjustable by varying the dopant concentration used in step b) and/or the material system. The material system preferably refers to the choice of the polymer used in step a) and/or to the choice of the dopant used in step b). Thus, the conductivity of the of the doped organic nanoparticles can be adjusted by using different types and/or amounts of dopants and/or different polymers. The conductivity of the doped organic nanoparticles is preferably adjustable in the range of 10⁻³ to 10⁻¹ S/m, more preferably in the range of 10⁻⁴ to 1 S/m. Thereby, charge transport can advantageously be enhanced.

Furthermore, the work function of the doped organic nanoparticles is preferably adjustable by varying the dopant concentration used in step b) and/or the material system. The material system preferably refers to the choice of the polymer used in step a) and/or to the choice of the dopant used in step b). Thus, the work function of the of the doped organic nanoparticles can be adjusted by using different types and/or amounts of dopants and/or different polymers. For example, the work function of F4-TCNQ doped P3HT organic nanoparticles varies from 4.4 eV to 4.6 eV for pristine P3HT and 5 wt% doped P3HT, respectively. In particular, the work function of the doped organic nanoparticles is adapted by the choice of the polymer. The work functions of the individual polymers can be very different. This advantageously offers a wide range for adjusting the work function of the doped organic nanoparticles. Thus, the work function of the doped organic nanoparticles is advantageously highly tailorable.

The full name of P3HT is poly-3-hexylthiophen. The full name of F4-TCNQ is 2,3,5,6-Tetrafluoro-7,7,8,8-tetracyanoquinodimethane.

Thus, conductivity and work function of the doped organic nanoparticles can be optimized separately by varying the dopant concentration and/or the material system. Thus, the doped organic nanoparticles are advantageously highly tailorable.

The ink properties of the dispersion of the doped organic nanoparticles and film forming properties are preferably adjusted by the choice of the solvent, the particle size and the dimensionality of the nanostructures over a wide range. Regarding the dimensionality, nanoparticles are considered to be 0-dimensional. However, the nanostructure of the film can be changed by different stackings. Thereby, a scalable production is advantageously facilitated.

Advantageously, the proposed method is facile and versatile.

By means of the method according to the invention, the functional key properties of the doped organic nanoparticles can be advantageously tailored independently from each other over a wide regime. In particular, conductivity and work function of the doped organic nanoparticles can advantageously be fine-tuned. Thus, the electronic properties of the doped organic nanoparticles show a high variability and a point-specific adaptation. Thereby, charge transport can advantageously be enhanced.

Advantageously, the doped organic nanoparticles can be realized by different polymers and/or different dopants. Thus, the method is advantageously universally applicable.

Advantageously, the doped organic nanoparticles can be deposited on all types of substrates, also on organic layers to fabricate functional layers. Advantageously, the doped organic nanoparticles do not dissolve the organic layers because of the alcoholic dispersion.

Furthermore, the doped organic nanoparticles advantageously provide suitable energy levels to support charge extraction.

The doped organic nanoparticles can advantageously be implemented as hole transporting layer in organic solar cells. Organic solar cells based on P3HT and O-IDTBR obtain a champion efficiency of 6.7%, while a high power conversion efficiency (PCE) of 12% is achieved for PM6:Y6 organic solar cells, which is among the highest power conversion efficiency (PCE) values reported for inverted non-fullerene organic solar cells with a solution-processed hole transporting layer.

Furthermore, according to the invention, a method for producing a functional layer for an organic semiconductor device is claimed. The method comprises the following steps, in particular in the following order:
a) dissolving a semiconducting polymer in a solvent to form a solution,
b) adding a dopant to the solution,
c) receiving a pre-assembled structure formed by strong interactions between the polymer-chains induced by doping,
d) injecting the solution into an antisolvent, preferably into an alcohol based antisolvent,
e) receiving a precipitation of doped organic nanoparticles as a dispersion, wherein the doped organic nanoparticles are formed by the pre-assembled structure encapsulating the dopant,
f) evaporating the solvent,
g) forming the functional layer.

It is further possible that the method steps are carried out once or several times. In particular, method steps and sub-steps may be repeated. The preferred sequence of the method steps has at least the sequence of step a) - step b) - step c) - step d) - step e) - step f) - step g), whereby in particular further steps or sub-steps can be inserted between these steps.

The solution formed in step a) can also be called precursor solution.

In step b), the dopant is preferably added to the solution with concentrations in the range of 1 to 25 wt%, more preferably in the range of 5 to 15 wt%, most preferably in the range of 9 to 11 wt%. These dopant concentrations are supposed to be moderate concentrations.

In step e), the precipitation of doped organic nanoparticles is preferably received as a colloidal dispersion.

The preparation of the functional layer comprising the doped organic nanoparticles is preferably performed by a nanoprecipitation technique. By the injection of the solution, preferably chloroform-based solution, into the alcohol based antisolvent, a condition of high supersaturation is preferably realized. In consequence, rapid precipitation is preferably achieved. This preferably triggers nucleation and growth of the doped organic nanoparticles. The dopant is preferably encapsulated in the doped organic nanoparticles.

In particular, the doped organic nanoparticles contain polymer and dopant. The properties of the functional layer and/or of the doped organic nanoparticles can be adjusted by using different types and/or amounts of dopants and/or different polymers. In particular, each polymer has different properties (conductivities, energy level, etc.). Thus, by varying the combination of dopant and polymer, the properties of the functional layer and/or of the doped organic nanoparticles can be adjusted. For example, the doping effect is preferably different between polymers with different structures and energy levels.

Preferably, the conductivity of the functional layer and/or of the doped organic nanoparticles is adjustable by varying the dopant concentration used in step b) and/or the material system. The material system preferably refers to the choice of the polymer used in step a) and/or to the choice of the dopant used in step b). Thus, the conductivity of the functional layer and/or of the doped organic nanoparticles can be adjusted by using different types and/or amounts of dopants and/or different polymers. The conductivity of the functional layer and/or of the doped organic nanoparticles is preferably adjustable in the range of 10⁻³ to 10⁻¹ S/m, more preferably in the range of 10⁻⁴ to 1 S/m. Thereby, charge transport can advantageously be enhanced.

Furthermore, the work function of the functional layer and/or of the doped organic nanoparticles is preferably adjustable by varying the dopant concentration used in step b) and/or the material system. The material system preferably refers to the choice of the polymer used in step a) and/or to the choice of the dopant used in step b). Thus, the work function of the functional layer and/or of the doped organic nanoparticles can be adjusted by using different types and/or amounts of dopants and/or different polymers. For example, the work function of F4-TCNQ doped P3HT organic nanoparticles varies from 4.4 eV to 4.6 eV for pristine P3HT and 5 wt% doped P3HT, respectively. In particular, the work function of the functional layer and/or of the doped organic nanoparticles is adapted by the choice of the polymer. The work functions of the individual polymers can be very different. This advantageously offers a wide range for adjusting the work function of the functional layer and/or of the doped organic nanoparticles. Thus, the work function of the functional layer and/or of the doped organic nanoparticles is advantageously highly tailorable.

The full name of P3HT is poly-3-hexylthiophen. The full name of F4-TCNQ is 2,3,5,6-Tetrafluoro-7,7,8,8-tetracyanoquinodimethane.

Thus, conductivity and work function of the functional layer and/or of the doped organic nanoparticles can be optimized separately by varying the dopant concentration and/or the material system. Thus, the functional layer and/or the doped organic nanoparticles are advantageously highly tailorable.

The ink properties of the dispersion of the doped organic nanoparticles and film forming properties are preferably adjusted by the choice of the solvent, the particle size and the dimensionality of the nanostructures over a wide range. Regarding the dimensionality, nanoparticles are considered to be 0-dimensional. However, the nanostructure of the film can be changed by different stackings. Thereby, a scalable production is advantageously facilitated.

Advantageously, the proposed method is facile and versatile.

By means of the method according to the invention, the functional key properties of the functional layer and/or of the doped organic nanoparticles can be advantageously tailored independently from each other over a wide regime. In particular, conductivity and work function of the functional layer and/or of the doped organic nanoparticles can advantageously be fine-tuned. Thus, the electronic properties of the functional layer and/or of the doped organic nanoparticles show a high variability and a point-specific adaptation. Thereby, charge transport can advantageously be enhanced.

Advantageously, the doped organic nanoparticles can be realized by different polymers and/or different dopants. Thus, the method is advantageously universally applicable.

Advantageously, the functional layer comprising the doped organic nanoparticles can be deposited on all types of substrates, also on organic layers. Advantageously, the functional layer comprising the doped organic nanoparticles does not dissolve the organic layers because of the alcoholic dispersion.

Furthermore, the doped organic nanoparticles advantageously provide suitable energy levels to support charge extraction.

The functional layer comprising the doped organic nanoparticles can advantageously be a hole transporting layer in organic solar cells. Organic solar cells based on P3HT and O-IDTBR obtain a champion efficiency of 6.7%, while a high power conversion efficiency (PCE) of 12% is achieved for PM6:Y6 organic solar cells, which is among the highest power conversion efficiency (PCE) values reported for inverted non-fullerene organic solar cells with a solution-processed hole transporting layer.

Further advantageous embodiments of the invention are indicated in the dependent claims.

According to an advantageous embodiment of the invention, the semiconducting polymer is selected from the group comprising P3AT, P3BT, P3HT, P3OT, PTAA, Spiro-OMeTAD, PBDB-T, PJ1, N2200, PolyTPD and combinations thereof.

The full name of P3AT is poly-3-alkylthiophen. The full name of P3BT is poly-3-butylthiophen. The full name of P3HT is poly-3-hexylthiophen. The full name of P3OT is poly-3-octylthiophen. The full name of PTAA is poly[bis(4-phenyl)-(2,4,6-trimethyl phenyl)amine].

The full name of Spiro-OMeTAD is 2,2',7,7'-tetrakis(N,N'-di-p-methoxyphenylamine)-9,9'-spirobifluorene.

The full name of PBDB-T is Poly[(2,6-(4,8-bis(5-(2-ethylhexyl)thiophen-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione)]).

The full name of PJ1 is Poly[[12,13-bis(2-decyltetradecyl)-12,13-dihydro-3,9-diundecylbisthieno [2",3":4',5']thieno[2',3':4,5]pyrrolo[3,2-e:2',3'-g]

[2,1,3]benzothiadiazole-2,10-diyl]methylidyne [1-(dicyanomethylene)-1,3-dihydro-3-oxo-2H-inden-?-yl-2-ylidene]-2,5-thiophenediyl[1-(dicyanomethylene) -1,3-dihydro-3-oxo-2H-inden-?-yl-2-ylidene]methylidyne]).

The full name of N2200 is poly{[N,N'-bis (2-octyldodecyl)- naphthalene-1,4,5,8-bis(dicarboximide)-2,6-diyl]-alt-5,5'-(2,29-bisthiophene)}).

The full name of PolyTPD is Poly[N,N'-bis(4-butylphenyl)-N,N'-bisphenylbenzidine])).

According to a further advantageous embodiment of the invention, the solvent is selected from the group comprising chloroform, dichloromethane, tetrahydrofuran, and combinations thereof.

According to a further advantageous embodiment of the invention, the dopant is selected from the group comprising Lewis acid dopant, F4-TCNQ, F2TCNQ, F6TCNNQ, CN6-CP, piperazine, TBAOH and combinations thereof.

The Lewis acid dopant is abbreviated as LAD. The Lewis acid dopant is, for example, tris(pentafluorophenyl)borane.

The full name of F4-TCNQ is 2,3,5,6-Tetrafluoro-7,7,8,8-tetracyanoquinodimethane.

The full name of TBAOH is tetrabutylammonium hydroxide.

Furthermore, the dopant can contain iron.

According to a further advantageous embodiment of the invention, the method comprises the following step, in particular between step b) and c):
h) stirring the solution during a time in a range of 2 to 48 hours, preferably in a range of 8 to 30 hours, more preferably in a range of 12 to 24 hours, most preferably in a range of 18 to 22 hours at a temperature in the range of 0 to 40 °C, preferably in the range of 15 to 25 °C, more preferably in the range of 18 to 22 °C.

According to a further advantageous embodiment of the invention, the antisolvent is selected from the group comprising isopropanol, ethanol, 3-hexanol, isobutanol, tert-butanol and combinations thereof.

Accordingly, the antisolvent is alcohol-based. Thus, an alcoholic dispersion is formed. The alcoholic dispersion readily can be applied to organic layers for forming the functional layer thereon. In particular, the alcoholic dispersion and/or the functional layer do not dissolve the organic layer thereunder. Thus, advantageously, the functional layer can be deposited on all types of substrates including organic layers.

According to a further advantageous embodiment of the invention, the functional layer is formed in step g) by doctor blading, spin coating, spray coating, ink-jet printing and/or screen-printing of the dispersion.

The doctor blading of the dispersion is preferably carried out in air.

According to a further advantageous embodiment of the invention, the method comprises the following step, in particular after step g):
i) annealing of the functional layer,
wherein the annealing is preferably carried out at a temperature in the range of 50 to 130 °C, more preferably in the range of 80 to 110 °C, and wherein the annealing is preferably carried out during a time in the range of 20 s to 20 min, more preferably in the range of 2 to 10 min.

The annealing of the functional layer is preferably carried in a glovebox.

Furthermore, according to the invention, a functional layer of an organic semiconductor device, preferably produced by the method according to claim 2, wherein the functional layer comprises doped organic nanoparticles produced by means of a semiconducting polymer, a solvent, a dopant, and an antisolvent, preferably an alcohol based antisolvent.

The dopant has preferably a moderate concentration. In particular, the dopant has a concentration in the range of 1 to 25 wt%, preferably in the range of 5 to 15 wt%, more preferably in the range of 9 to 11 wt%.

The dopant is preferably encapsulated in the doped organic nanoparticles.

The doped organic nanoparticles are fabricated via forming a pre-assembled structure in a solution, also called the precursor solution.

The doped organic nanoparticles are preferably alcohol based.

In particular, the doped organic nanoparticles contain polymer and dopant. The properties of the functional layer and/or of the doped organic nanoparticles can be adjusted by using different types and/or amounts of dopants and/or different polymers. In particular, each polymer has different properties (conductivities, energy level, etc.). Thus, by varying the combination of dopant and polymer, the properties of the functional layer and/or of the doped organic nanoparticles can be adjusted. For example, the doping effect is preferably different between polymers with different structures and energy levels.

Preferably, the conductivity of the functional layer and/or of the doped organic nanoparticles is adjustable by varying the dopant concentration used in step b) and/or the material system. The material system preferably refers to the choice of the polymer used in step a) and/or to the choice of the dopant used in step b). Thus, the conductivity of the functional layer and/or of the doped organic nanoparticles can be adjusted by using different types and/or amounts of dopants and/or different polymers. The conductivity of the functional layer and/or of the doped organic nanoparticles is preferably adjustable in the range of 10⁻³ to 10⁻¹ S/m, more preferably in the range of 10⁻⁴ to 1 S/m. Thereby, charge transport can advantageously be enhanced.

Furthermore, the work function of the functional layer and/or of the doped organic nanoparticles is preferably adjustable by varying the dopant concentration used in step b) and/or the material system. The material system preferably refers to the choice of the polymer used in step a) and/or to the choice of the dopant used in step b). Thus, the work function of the functional layer and/or of the doped organic nanoparticles can be adjusted by using different types and/or amounts of dopants and/or different polymers. For example, the work function of F4-TCNQ doped P3HT organic nanoparticles varies from 4.4 eV to 4.6 eV for pristine P3HT and 5 wt% doped P3HT, respectively. In particular, the work function of the functional layer and/or of the doped organic nanoparticles is adapted by the choice of the polymer. The work functions of the individual polymers can be very different. This advantageously offers a wide range for adjusting the work function of the functional layer and/or of the doped organic nanoparticles. Thus, the work function of the functional layer and/or of the doped organic nanoparticles is advantageously highly tailorable.

The full name of P3HT is poly-3-hexylthiophen. The full name of F4-TCNQ is 2,3,5,6-Tetrafluoro-7,7,8,8-tetracyanoquinodimethane.

Thus, conductivity and work function of the functional layer and/or of the doped organic nanoparticles can be optimized separately by varying the dopant concentration and/or the material system. Thus, the functional layer and/or the doped organic nanoparticles are advantageously highly tailorable.

The ink properties of the dispersion of the doped organic nanoparticles and film forming properties are preferably adjusted by the choice of the solvent, the particle size and the dimensionality of the nanostructures over a wide range. Regarding the dimensionality, nanoparticles are considered to be 0-dimensional. However, the nanostructure of the film can be changed by different stackings. Thereby, a scalable production is advantageously facilitated.

Advantageously, the proposed functional layer is versatile and can be easily produced.

The functional key properties of the functional layer and/or of the doped organic nanoparticles can be advantageously tailored independently from each other over a wide regime. In particular, conductivity and work function of the functional layer and/or of the doped organic nanoparticles can advantageously be fine-tuned. Thus, the electronic properties of the functional layer and/or of the doped organic nanoparticles show a high variability and a point-specific adaptation. Thereby, charge transport can advantageously be enhanced.

Advantageously, the doped organic nanoparticles can be realized by different polymers and/or different dopants. Thus, the functional layer is advantageously universally applicable.

Advantageously, the functional layer comprising the doped organic nanoparticles can be deposited on all types of substrates, also on organic layers. Advantageously, the functional layer comprising the doped organic nanoparticles does not dissolve the organic layers because of the alcoholic dispersion.

Furthermore, the doped organic nanoparticles advantageously provide suitable energy levels to support charge extraction.

The functional layer comprising the doped organic nanoparticles can advantageously be a hole transporting layer in organic solar cells. Organic solar cells based on P3HT and O-IDTBR obtain a champion efficiency of 6.7%, while a high power conversion efficiency (PCE) of 12% is achieved for PM6:Y6 organic solar cells, which is among the highest power conversion efficiency (PCE) values reported for inverted non-fullerene organic solar cells with a solution-processed hole transporting layer.

According to an advantageous embodiment of the invention, the (alcohol based) doped organic nanoparticles have an average diameter in the range of 10 to 100 nm, preferably in the range of 20 to 70 nm, more preferably in the range of 40 to 60 nm.

According to a further advantageous embodiment of the invention, the functional layer is an electron or hole transport layer in a solar cell, in a light-emitting diode (LED), a photodetector or an X-ray detector.

The solar cell is preferably an organic solar cell, more preferably an inverted organic solar cell.

Moreover, the solar cell can be a perovskite solar cell.

Orthogonal solvents are preferably used to preserve the surface of the bulk heterojunction (BHJ) composites. Non-toxic alcohols are preferred over water as solvent system due to better wetting properties and faster drying.

The conductivity of the doped organic nanoparticles is preferably adjustable in the range of 10⁻³ to 10⁻¹ S/m, more preferably in the range of 10⁻⁴ to 1 S/m.

By this variable doping, the work function of the hole transport layer preferably matches the p-type quasi-Fermi level of the bulk heterojunction (BHJ) for comparable HOMO levels.

The hole transport layer has preferably a HOMO level which is not significantly offset from the HOMO level of the bulk heterojunction (BHJ) system. Preferably, this offset accounts to 0.001 to 0.5 eV, more preferably to 0.01 to 0.4 eV, most preferably to 0.1 to 0.3 eV.

Advantageously, the hole transport layer can be easily fine-tuned and tailored for each single bulk heterojunction (BHJ) system without compromising between performance and processing properties.

The hole transport layer advantageously provides suitable energy levels for the bulk heterojunction (BHJ).

Preferably, the hole transport layer comprises alcohol-based doped organic nanoparticles. Thus, integrity of the bulk heterojunction (BHJ) in vertical solution processing is preserved.

By using the doped organic nanoparticles as hole transport layer in the n-i-p architecture, a remarkable power conversion efficiency (PCE) of over 12% is advantageously achieved for PM6:Y6 based devices, which is among the top values for inverted organic solar cell using solution-processed hole transport layers.

According to a further advantageous embodiment of the invention, the functional layer is provided in a printed electronic device and/or in a thermoelectric device, and/or in artificial skin, and/or in an implant.

The printed electronic device is preferably an organic transistor, a resistor, or a conductor track. Furthermore, the printed electronic device can be a sensor, or a supercapacitor.

Furthermore, according to the invention, an organic semiconductor device comprising the inventive functional layer is claimed.

The organic semiconductor device can be a solar cell, preferably an organic solar cell, more preferably an inverted organic solar cell.

The functional layer and/or the doped organic nanoparticles comprised in the functional layer are preferably alcohol based.

The functional layer comprising the doped organic nanoparticles can advantageously be a hole transporting layer in organic solar cells. Organic solar cells based on P3HT and O-IDTBR obtain a champion efficiency of 6.7%, while a high power conversion efficiency (PCE) of 12% is achieved for PM6:Y6 organic solar cells, which is among the highest power conversion efficiency (PCE) values reported for inverted non-fullerene organic solar cells with a solution-processed hole transporting layer.

According to an advantageous embodiment of the invention, the organic semiconductor device is a solar cell, and wherein the functional layer is an electron or hole transport layer of the solar cell.

The solar cell is preferably an organic solar cell, more preferably an inverted organic solar cell.

Moreover, the solar cell can be a perovskite solar cell.

The conductivity of the doped organic nanoparticles is preferably adjustable in the range of 10⁻³ to 10⁻¹ S/m, more preferably in the range of 10⁻⁴ to 1 S/m.

By using the doped organic nanoparticles as hole transport layer, organic solar cells based on P3HT and O-IDTBR obtain a champion efficiency of 6.7%, while a high PCE of 12% is achieved for PM6:Y6 OSCs, which is currently the highest value reported for inverted non-fullerene organic solar cells with a solution-processed hole transport layer.

According to a further advantageous embodiment of the invention, the organic semiconductor device is a light-emitting diode (LED), a photodetector or an X-ray detector, and wherein the functional layer is an electron or hole transport layer of the light-emitting diode (LED), the photodetector or the X-ray detector, respectively.

According to a further advantageous embodiment of the invention, the organic semiconductor device is a printed electronic device, a thermoelectric device, artificial skin or an implant.

The printed electronic device is preferably an organic transistor, a resistor, or a conductor track. Furthermore, the printed electronic device can be a sensor, or a supercapacitor.

Of course, the above-mentioned product features can also be used equivalently in a method or the above-mentioned method features can be used in the product.

In the following, the invention is explained by way of example on the basis of several embodiment examples with the aid of the enclosed figures. The embodiments shown are therefore not to be understood as restrictive.

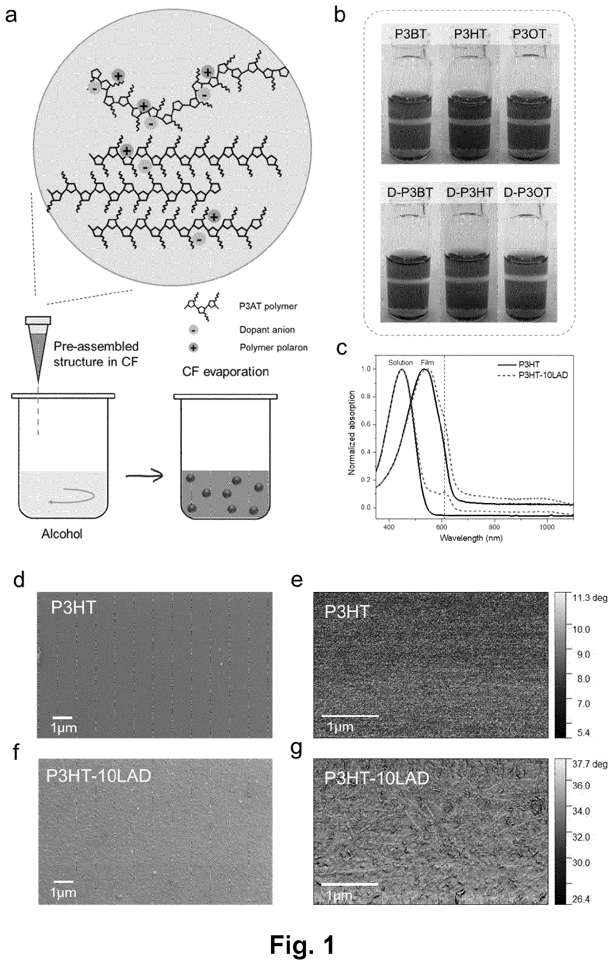

- Fig. 1: Preparation of doped organic nanoparticles.
(a) Schematic illustration of nanoprecipitation process for formation of doped organic nanoparticles (D-NPs) via forming pre-assembled structure method.
(b) Tyndall effect of P3AT derivatives (P3BT, P3HT and P3OT) nanoparticles and doped organic nanoparticles (D-P3BT, D-P3HT and D-P3OT).
(c) Ultraviolet-visible absorption of the P3HT and 10 wt% LAD (Lewis acid dopant) doped P3HT (abbreviated to P3HT-10LAD) solutions (dashed) and films (solid).
(d, f) SEM images and
(e, g) AFM phase images of P3HT and P3HT-10LAD films processed from solutions.

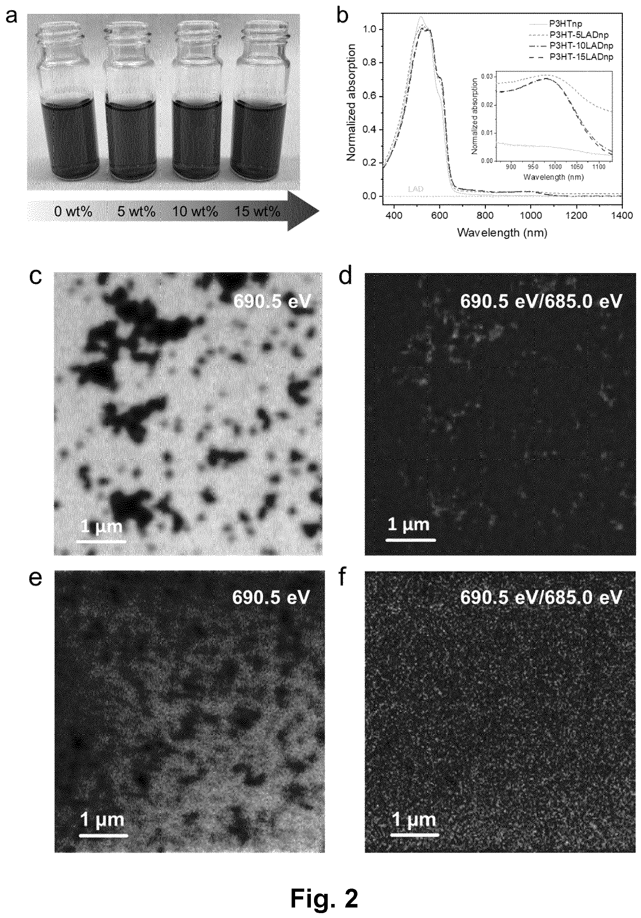

- Fig. 2: Characterization of doped P3HT nanoparticles (D-P3HTnp).
(a) Photographs and (b) Normalized (at 551 nm) UV-Vis absorption spectra of D-P3HTnp dispersions with different Lewis acid dopant (LAD) contents.
(c, e) STXM resonant maps of LAD mixed P3HTnp and D-P3HTnp, recorded at hv=690.5 eV in total electron yield mode, and
(d, f) corresponding normalized maps by division of resonant maps to off-resonant maps (690.5 eV/685.0 eV).

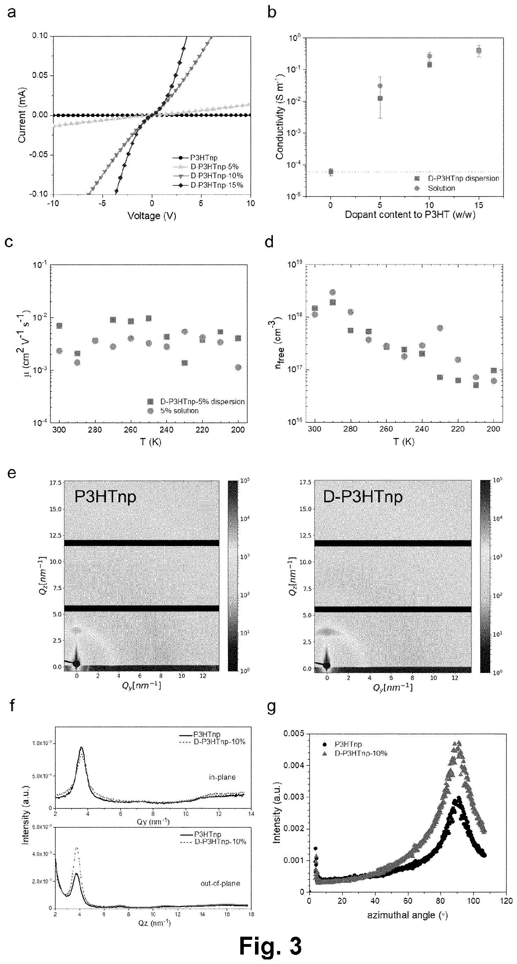

- Fig. 3: Electrical property and structures of films of doped P3HT nanoparticles (D-P3HTnp).
(a) I-V curves of D-P3HTnp films measured with interdigitated ITO substrates.
(b) Conductivities of D-P3HT films fabricated from D-NPs dispersions and chloroform (CF) solutions, as a function of dopant content to P3HT (w/w).
(c) Hole mobility and (d) Free charge carrier density of films from D-P3HTnp dispersion and D-P3HT solution.
(e) 2D GIWAXS data of P3HTnp and D-P3HTnp films.
(f) 1D scattering profiles (in-plane and out-of-plane) of P3HTnp and D-P3HTnp films.
(g) Azimuthal cut of (100) diffractions of P3HTnp and D-P3HTnp films.
- Fig. 4: Photovoltaic performance of the P3HT:O-IDTBR devices.
(a) J-V curves of the best organic solar cells (OSCs) under the illumination of AM 1.5 G.
(b) SEM of the D-P3HTnp layer on top of the active layer.
(c) Contact potential difference (CPD) area map of the active layer without and with LAD dopant treatment.
- Fig. 5: Photovoltaic performance of the PM6:Y6 devices.
(a) J-V curves of the best organic solar cells (OSCs) under the illumination of AM 1.5 G and
(b) EQE curves of organic solar cells (OSCs).
(c) Energy level diagram of Y6, PM6, P3HT, PTAA and Sprio-OMeTAD. Energy levels are estimated from literature values.
(d) Efficiency evolution of inverted organic solar cells (OSCs) based on solution-processed hole transport layer (HTL).
(e, f) SEM of the D-PTAAnp layer and D-Spiro-OMeTADnp layer on top of the active layers.

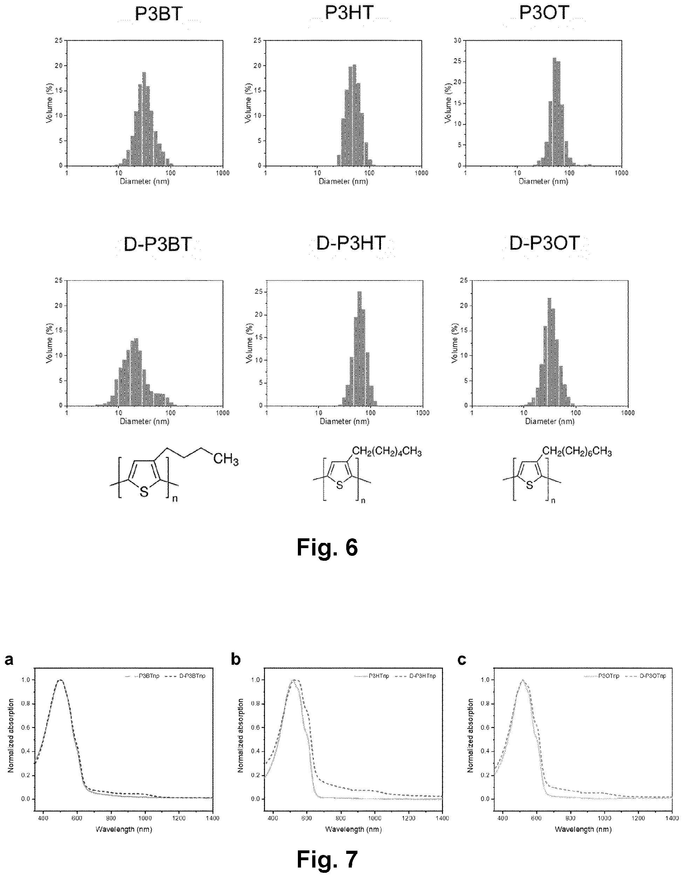

- Fig. 6: Size distribution of undoped and doped P3AT derivatives (P3BT, P3HT and P3OT), chemical structures of corresponding material are shown below.
- Fig. 7: UV-Vis absorption spectra of undoped and doped P3AT (a, P3BT; b, P3HT; c, P3OT) films processed from nanoparticle dispersions.

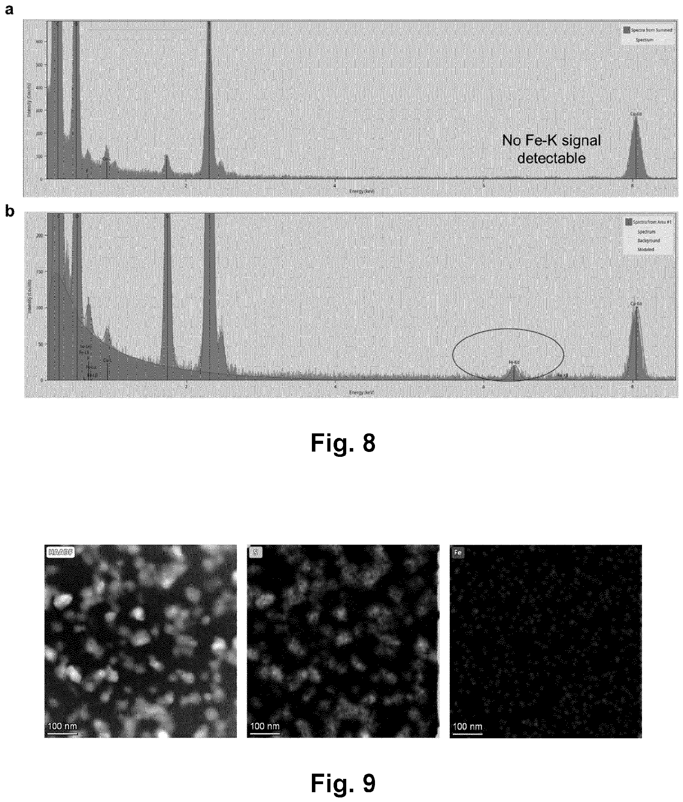

- Fig. 8: EDX spectra of (a) P3HTnp and (b) D-P3HTnp with iron-containing dopant.
- Fig. 9: HAADF-STEM and STEM-EDX elemental mapping image of D-P3HTnp with iron-containing dopant.

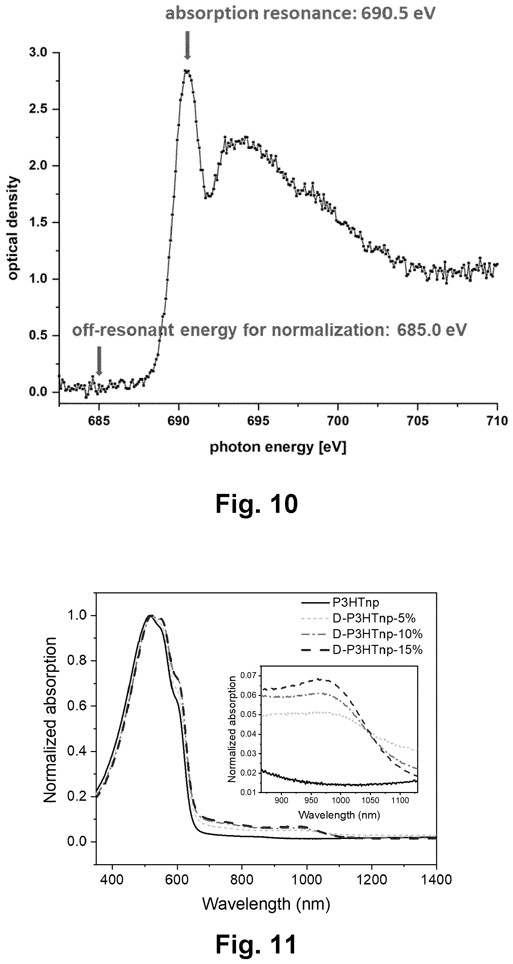

- Fig. 10: F K-edge NEXAFS spectra of LAD dopant.
- Fig. 11: Normalized UV-Vis absorption spectra of D-P3HTnp films with different LAD contents.

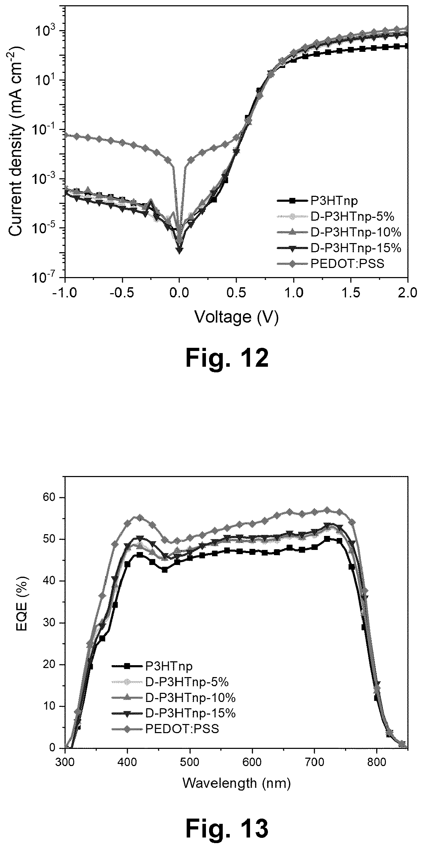

- Fig. 12: Dark currents of P3HT:O-IDTBR organic solar cells (OSCs).
- Fig. 13: EQE curves of P3HT:O-IDTBR organic solar cells (OSCs) with different hole transport layers (HTLs).

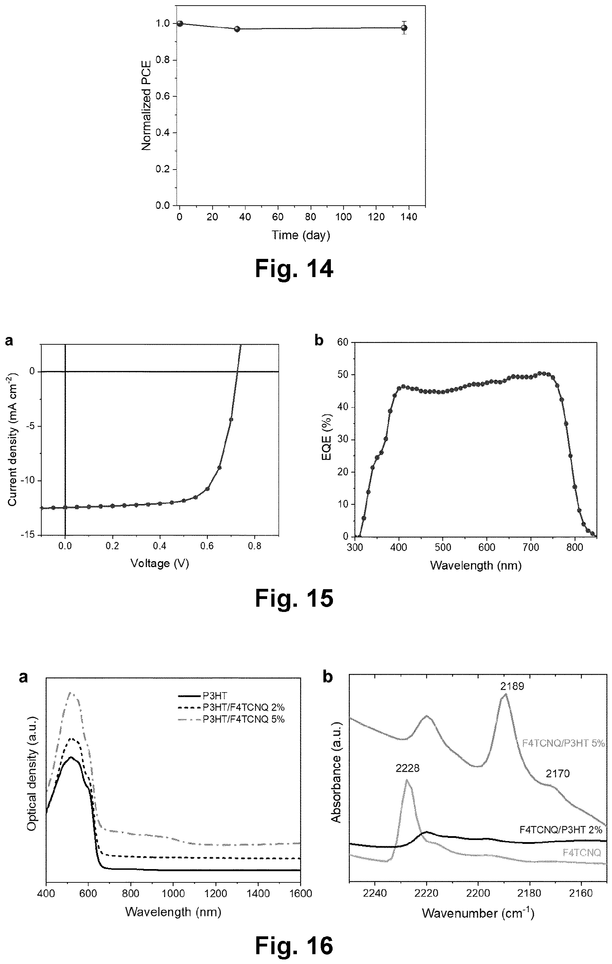

- Fig. 14: Storage stability of P3HT:O-IDTBR organic solar cells (OSCs) based on D-P3HTnp (10 wt% LAD) under ambient condition without encapsulation.
- Fig. 15: (a) J-V curves of P3HT:O-IDTBR organic solar cells (OSCs) based on D-P3BTnp and (b) EQE thereof.
- Fig. 16: (a) UV-Vis absorption spectra and (b) FTIR spectra of D-P3HTnp with different dopant contents.

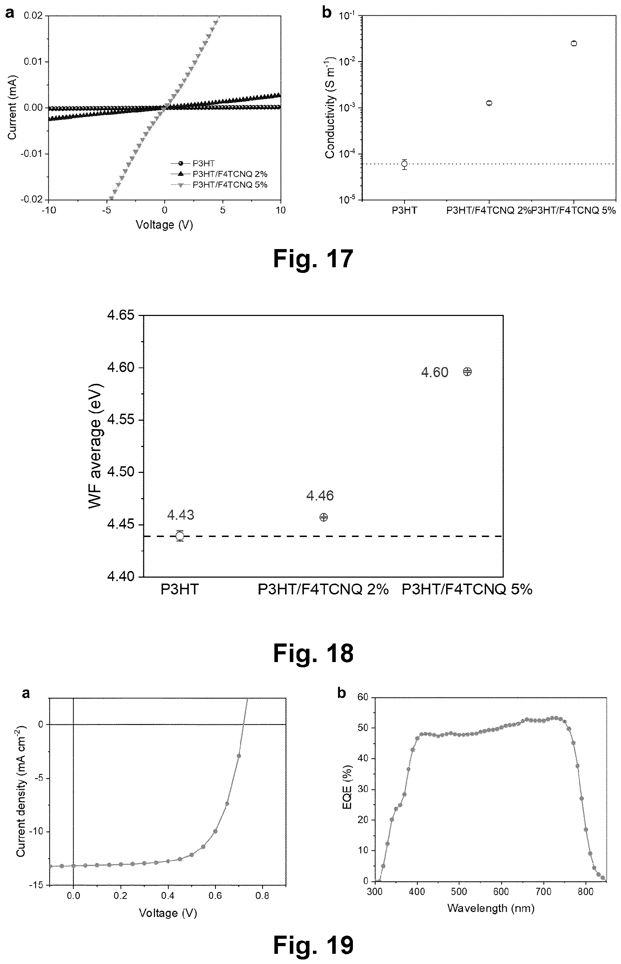

- Fig. 17: (a) I-V curves of D-P3HTnp films measured with interdigitated ITO substrates. (b) Calculated conductivities from I-V curves.
- Fig. 18: Work function (WF) values of D-P3HTnp films with different dopant contents.
- Fig. 19: (a) J-V curves of P3HT:O-IDTBR organic solar cells (OSCs) based on D-P3HTnp with F4-TCNQ and (b) EQE thereof.

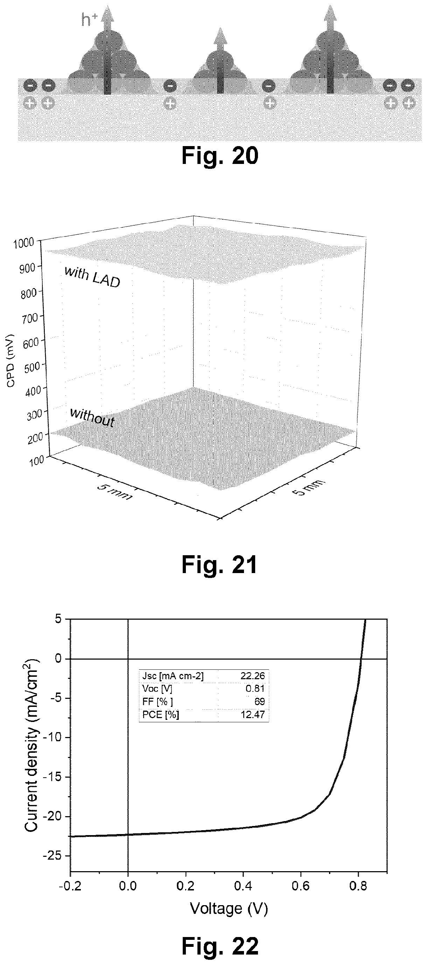

- Fig. 20: Schematic illustration of hole transfer at the active layer / D-P3HTnp interface.
- Fig. 21: Contact potential difference (CPD) area map of PM6:Y6 active layer without and with LAD dopant treatment.
- Fig. 22: J-V curve of PM6:Y6 organic solar cells (OSCs) based on evaporated MoOx.

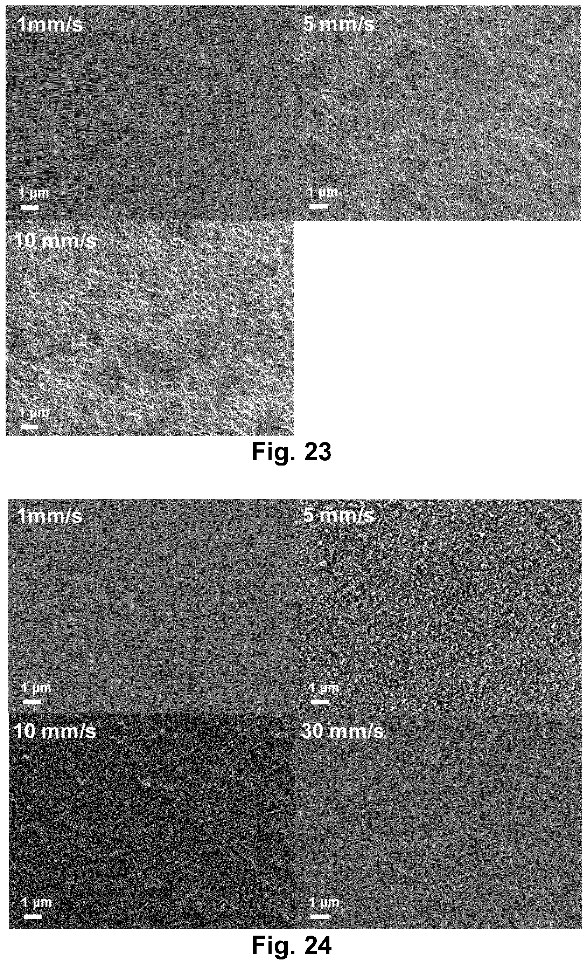

- Fig. 23: SEM of D-Spiro-OMeTADnp layer on top of the active layer.
- Fig. 24: SEM of D-PTAAnp layer on top of the active layer.

The preparation of doped organic nanoparticles (D-NPs) via forming a pre-assembled structure method is shown in Figure 1a. Semiconducting polymers are first dissolved in chloroform (CF). A typical Lewis acid dopant (tris(pentafluorophenyl)borane, abbreviated as LAD) with moderate concentrations (e. g. 10 wt%) is added to the solution and stirred overnight (15 hours). Doping induced strong interactions between the polymer chains occur and produce a pre-assembled structure. The evidence of the pre-assembled structure is observed from the ultraviolet-visible absorption spectra, which exhibited an increased intensity of 0-0 transition at 610 nm and a polaron-related absorption at 980 nm (Figure 1c). A rough film morphology processed from dopant added solutions is also observed, while the one from a pure P3HT solution is quite smooth (Figure 1d and 1f). Accordingly, the rougher morphology is caused by the pre-assembled structure being retained during processing. In the atomic force microscopy (AFM) phase images, the doped P3HT film exhibits a clear fibril structure (Figure 1e and 1g). The second step in the preparation of doped organic nanoparticles (D-NPs) is performed by a nanoprecipitation technique. When chloroform-based solutions are injected into alcohol based antisolvents, rapid precipitation is achieved by imposing a condition of high supersaturation. This triggers nucleation and growth of organic nanoparticles, leaving the dopant encapsulated in the polymer aggregates. The doped organic nanoparticles (D-NPs) dispersion is ready to be used directly after evaporation of chloroform (CF). A series of poly-3-alkylthiophen (P3AT) derivatives, namely P3B(utyl)T, P3H(exyl)T and P3O(ctyl)T are fabricated into undoped and doped organic nanoparticles dispersions using this method. The good colloidal dispersion of all the NPs is confirmed from the Tyndall effect (Figure 1b). No noticeable change in the average size distribution of the doped organic nanoparticles (D-NPs) is observed after doping (Figure 6).

Taking doped P3HT nanoparticles (D-P3HTnp) as an example, the dispersions showed a gradual color change starting from purple-red to dark purple as the dopant content increased (Figure 2a). Figure 2b shows the optical absorption spectra of D-P3HTnp dispersions as a function of dopant concentration. Pure P3HTnp dispersions show three spectral features at 518, 551 and 598 nm, originating from the π-π* transition along or across the conjugated backbones. Obviously, a more pronounced 0-0 vibronic transition (at 598 nm) in D-P3HTnp dispersions indicates an enhanced P3HT order in the nanoparticle structure. To a lesser degree, red shifts in the absorption of the D-P3HT dispersions are observed, suggesting a larger fraction of more planar chains with increased conjugation length, obviously induced by the presence of the dopant. In addition, sharp characteristic features for the P3HT polaron in the infrared region can be seen at the low dopant content of 5 wt%, which increased in intensity with the dopant content. D-P3HTnp are further investigated by high-angle annular dark-field scanning transmission electron microscopy (HAADF STEM) in order to clarify whether the dopants are located more inside the nanoparticles or rather on the outside. An iron-containing dopant is used here instead of the Lewis acid dopant (LAD) dopant, since the low atomic number elements in the LAD dopant are difficult to detect using energy-dispersive X-ray (EDX). HAADF STEM of D-P3HTnp showed a diameter size of 50 nm, in agreement with the dynamic light scattering (DLS) and scanning electron microscopy (SEM) measurement. Further EDX elements mapping (Figure 8 and 9) analysis exhibits the simultaneous presence of S and Fe, indicating that the iron-containing dopant exists in the D-P3HTnp. To determine the dopant position within the nanoparticle, surface sensitive scanning transmission X-ray microscopy (STXM) in total electron yield (TEY) mode are performed. The F *K-*edge absorption resonance of LAD is determined to be 690.5 eV by near-edge X-ray absorption fine structure (NEXAFS) spectroscopy (Figure 10). Normalized maps depicting surface enrichment of LAD are obtained by division of corresponding resonant STXM micrographs to off-resonant micrographs. For comparison, LAD mixed P3HTnp are prepared just by adding dopant into the nanoparticle dispersion. The surface enrichment of the F signal is clearly seen from the normalized TEY map of the mixed P3HTnp, which proves the presence of dopant on the top of the nanoparticles (Figure 2c and 2d). Notably, however, the normalized TEY map of the D-P3HTnp does not reflect the particle agglomerations, suggesting the dopant is not enriched at the surface (Figure 2e and 2f). All these results highlight the successful synthesis of homogenously doped P3HT nanoparticles, D-P3HTnp.

The electrical conductivity of films of doped P3HT nanoparticles (D-P3HTnp) as a function of dopant content is estimated by measuring the current-voltage (I-V) curves of the films with interdigitated ITO substrates (Figure 3a). The calculated data are plotted in Figure 3b, with the conductivity of the films processed from the corresponding solution as a reference. Pure P3HT films have a conductivity as low as 6 × 10⁻⁵ S m⁻¹. When doped with 5 wt% dopant, the conductivity is greatly enhanced by two orders of magnitude. By gradually increasing the dopant content to 15 wt%, the conductivity is considerably improved and reaches the highest value of 10⁻¹ S m⁻¹, which is ascribed to the p-type doping effect. Notably, the conductivities of films prepared from the D-P3HTnp dispersions are close to the ones from solutions. This is particularly important for the development of multilayer organic optoelectronic devices. In order to isolate the two contributions to conductivity - microstructure induced mobility changes and carrier density modification due to doping, Hall effect measurements are performed. Figure 3c and 3d show that the D-P3HTnp films have the expected p-type conductivity with the mobility of 3 × 10⁻³ cm²V⁻¹s⁻¹ and the carrier concentration of 1 × 10¹⁸ cm⁻³ at room temperature (300 K). These mobility values are comparable to previous findings for undoped P3HT. Therefore, the increase of the conductivity is mainly induced by the hole carrier concentrations. The temperature-independent mobility suggests homogeneous bulk-doped structure, no significant anomalous Hall effect due to inhomogeneous distribution of dopant, which is also confirmed by STXM measurement.

Grazing-incidence wide-angle X-ray scattering (GIWAXS) is carried out to determine the microstructure of the doped P3HT nanoparticles (D-P3HTnp) film (Figure 3e-3g). Figure 3e presents two-dimensional GIWAXS profiles of the pristine P3HT film and D-P3HTnp film. For pristine P3HT film, a diffusive elliptical-like pattern is observed along the out-of-plane direction at Q_{z} (nm⁻¹) = 3.74, due to the lamellar stacking of alkyl chains with a d-spacing of 1.68 nm. An additional weak signal appears at Q_{xy} (nm⁻¹) = 3.61. For D-P3HTnp film, an intense signal appears for the (100) plane along the Q_{z} axis. This is confirmed by the 1D cuts of the 2D images of the P3HT and the D-P3HTnp films in Fig. 3f which clearly show that the edge-on orientation is stronger with the D-P3HTnp film. This is also evidenced by the azimuthal cuts along the (100) peak of P3HTnp and D-P3HTnp films (Figure 3g). Previous reports on sequential-processing and vapor-doped polymer: F4-TCNQ films proposed that F4-TCNQ resides in the amorphous regions of the film as well as in the lamellae between the side chains. In the case of LAD, a shift of (100) peak of D-P3HTnp film is not observed, which may indicate that the dopant primarily resides in the amorphous regions close to the crystallites.

| **Table 1 Photovoltaic parameters of P3HT:O-IDTBR devices.** | | | | | | |
|---|---|---|---|---|---|---|
| **HTLs** | **Jsc [mA cm⁻²]** | **Jsc by EQE [mA cm⁻²]** | **Voc [V]** | **FF [%]** | **PCE [%]** | |
| | | | | | **Average** | **Best** |
| w/o HTL | 11.11 | 11.68 | 0.18 | 36.5 | 0.65 ± 0.05 | 0.72 |
| P3HTnp | 12.27 | 12.12 | 0.68 | 65.1 | 5.29 ± 0.03 | 5.33 |
| LAD | 8.63 | 8.90 | 0.58 | 49.7 | 2.20 ± 0.23 | 2.48 |
| D-P3HTnp-10% | 13.02 | 12.90 | 0.73 | 69.9 | 6.57 ± 0.08 | 6.60 |
| D-P3BTnp-10% | 12.99 | 12.46 | 0.73 | 71.2 | 6.46 ± 0.17 | 6.74 |
| D-P3HT with F4-TCNQ | 13.24 | 13.17 | 0.72 | 65.3 | 6.14 ± 0.09 | 6.24 |
| PEDOT:PSS | 14.38 | 14.09 | 0.72 | 0.54 | 5.38 ± 0.10 | 5.53 |

| **Table 2 Photovoltaic parameters of the best PM6:Y6 devices.** | | | | |
|---|---|---|---|---|
| **HTLs** | **Jsc [mA cm⁻²]** | **Voc [V]** | **FF [%]** | **PCE [%]** |
| D-P3HTnp | 16.46 | 0.82 | 63.4 | 8.56 |
| D-PTAAnp | 20.86 | 0.80 | 61.3 | 10.19 |
| D-Spiro-OMeTADnp | 22.79 | 0.81 | 64.9 | 12.00 |
| PEDOT:PSS | 21.78 | 0.64 | 56.0 | 7.76 |

**Table 3. Photovoltaic parameters of P3HT:O-IDTBR organic solar cells (OSCs).**

| **HTLs** | **Jsc [mA cm⁻²]** | **Jsc by EQE [mA cm⁻²]** | **Voc [V]** | **FF [%]** | **PCE** | | **R series [Ω cm⁻²]** | **R shunt [Ω cm⁻²]** |
|---|---|---|---|---|---|---|---|---|
| | | | | | **Average** | **Best** | | |
| D-P3HTnp-5% | 12.94 | 12.89 | 0.72 | 66.5 | 6.16 ± 0.22 | 6.19 | 1.77 | 1.91E+06 |
| D-P3HTnp-10% | 13.02 | 12.90 | 0.73 | 69.9 | 6.57 ± 0.08 | 6.60 | 1.26 | 1.96E+06 |
| D-P3HTnp-15% | 13.31 | 13.13 | 0.72 | 68.4 | 6.38 ± 0.28 | 6.55 | 1.95 | 2.90E+06 |

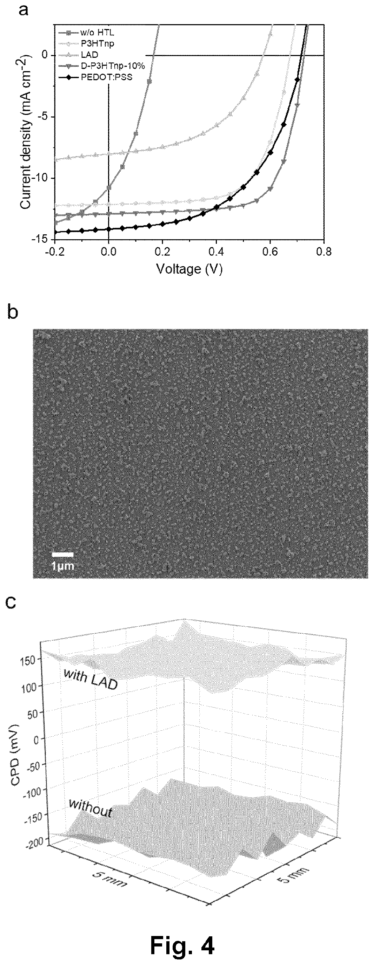

The impact of the doped P3HT nanoparticles (D-P3HTnp) as hole transport layer (HTL) on photovoltaic performance is investigated in detail. The corresponding photovoltaic parameters for organic solar cells (OSCs) based on different dopant concentrations are summarized in Table 1 and Table 3. Accordingly, the optimal dopant concentration is 10 wt%. The reference organic solar cells (OSCs) with pure P3HTnp exhibited a respectable power conversion efficiency (PCE) of 5.33%, which is comparable to the reference one with PEDOT:PSS as hole transport layer (HTL). Notably, devices from undoped P3HTnp exhibited a larger fill factor (FF) than the ones with PEDOT:PSS, despite their relatively larger series resistance (Figure 12). A significant further improvement of all performance parameters is found when D-P3HTnp are employed as hole transport layer (HTL), with the enhancement in fill factor (FF) being the most notable one. The champion device based on D-P3HTnp-10% achieved the highest power conversion efficiency (PCE) of 6.60%, with a short-circuit current density (Jsc) of 13.02 mA cm⁻², an open-circuit voltage (Voc) of 0.73 V, and a fill factor (FF) of 69.9%. The higher short-circuit current density (Jsc) and fill factor (FF) are attributed to the higher conductivity that promotes effective hole extraction and the close energy level match between hole transport layer (HTL) and the active layer. It is worth noting that the D-P3HTnp layer reveals not only a low series resistance, but also an excellent shunt resistance. The shelf-stability of unencapsulated devices based on D-P3HTnp under ambient conditions is also monitored. The device maintains about 97% of its initial efficiency over 100 days (Figure 14). Interestingly, the doped nanoparticles strategy is also applicable to other P3AT derivatives like P3BT and other dopants like for instance F4-TCNQ (Figures 16 to 19). The D-P3BTnp-10% achieved a power conversion efficiency (PCE) of 6.74%, which is the highest reported for fullerene-free P3HT devices with an inverted structure (Table 1 and Figure 15). The integrated short-circuit current density (Jsc) from the external quantum efficiency (EQE) measurement agrees well with the short-circuit current density (Jsc) values measured under AM 1.5G one sun illumination (Figure 13). Having learned from STXM that the thin film microstructure is still dominated by the particle character of D-P3HTnp, a closer look is taken on the possibly layer quality of the nanoparticle processed hole transport layer (HTL). Interestingly, and in good agreement with the previous research, it is found that the nanoparticles form a mesoscopic structure on top of the active layer (Figure 4b). Areas with single nanoparticles or nanoparticle aggregates alternate with areas that appear to be uncovered. Usually, an incompletely covered interface is avoided in solar cells, since severe charge recombination happens when the metal electrode directly contacts the active layer. It is verified that as the hand of reference devices without hole transport layer (HTL). As expected, severe performance losses and an expressed reduction of the open-circuit voltage (Voc) underline the importance to electronically decouple the metal electrode from the semiconductor. As the D-P3HTnp solar cells have the highest fill factor (FF) and open-circuit voltage (Voc) among all hole transporting interfaces tested, interface recombination between the active semiconductor and the metal electrode can be ruled out. This raises the question on the nature of those areas which obviously are not covered by D-P3HTnp. As the inventive nanoparticle solutions contain partially dissolved LAD, excess LAD in the hole transport layer (HTL) solution could protect the uncovered area between the mesoscopic nanoparticles. A strong dopant like LAD will as well interact with the P3HT domains being close or at the surface of the bulk heterojunction (BHJ) composite. Kelvin probe measurements are used to directly probe the surface potential change of a P3HT:O-IDTBR layer which is coated with pristine LAD. From Figure 4c, the active layer with LAD dopant on top shows a ca. 340 mV up-shift in contact potential difference (CPD), which suggests that at the metal/active layer interface, the vacuum level of the anode is correspondingly elevated by 340 mV. These results are explained by an electric dipole with the positive charge end pointing toward the active layer and the negative charge end pointing toward the electrode. This is exactly the situation one would expect in case LAD interacts with P3HT on the surface by a doping reaction (Figure 20). This is further confirmed by a relative increase in open-circuit voltage (Voc) when spin-coating a thin LAD layer on top of the active layer compared to the one without. In summary, the mesoscopic structure of the D-P3HTnp layer plays a dual role in our devices: on the one hand, the D-P3HTnp align the work function and promotes better hole extraction. On the other hand, excess LAD p-dopes the P3HT on the surface of bulk heterojunction (BHJ) composite, thus forming a dipole in the areas which are not covered by nanoparticles. That dipole favorably lowers the work function for hole extraction and thus reduces interface recombination and charge recombination losses.

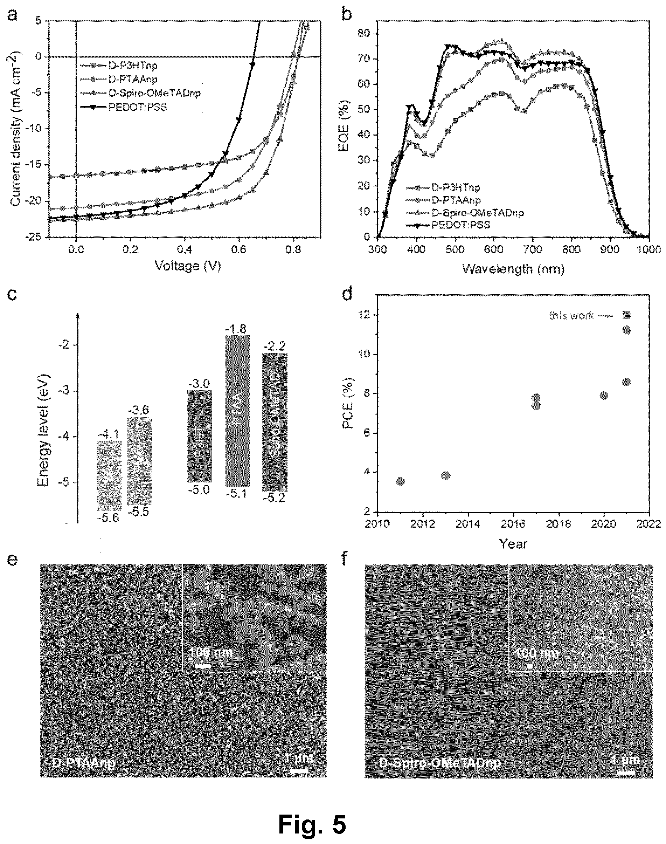

To prove the generality of the inventive doped organic nanoparticles (D-NPs), and especially of the mesoscopic arrangement, the currently most relevant state-of-the-art semiconductor system PM6:Y6 is investigated. PM6-Y6 is chosen because of the high performance with MoOx/Ag electrodes and because it is known to be prone to severe losses with PEDOT:PSS as interface layer. To better match the deeper HOMO level of PM6, further organic nanoparticles are developed based on material systems with a tentatively lower HOMO levels. Specifically, nanoparticles with PTAA and Spiro-OMeTAD following the same recipe as for D-P3HTnp are successfully fabricated. The energy levels of each material are presented in Figure 5c. These HOMO levels are determined under conditions different to the ones when being used as interface materials with P3HT:O-IDTBR and therefore, care should be taken when discussing the absolute values. In general, higher doping concentrations are necessary for PM6:Y6 in order to gain the full open-circuit voltage (Voc). This is likely a consequence of the deeper lying HOMO level of PM6 requiring a lower work function for the doped organic nanoparticles (D-NPs) systems in order to properly match the quasi Fermi level of P3HT at the anode interface.

The detailed photovoltaic performance of PM6:Y6 devices based on the three different doped organic nanoparticles (D-NPs) are shown in Table 4, and the photovoltaic parameters of each modified device are listed in Table 2. The devices based on PEDOT:PSS show the lowest power conversion efficiency (PCE) of 7.76%, while D-P3HTnp and D-PTAAnp devices achieved already higher power conversion efficiency (PCE) values of 8.56% and 10.19%, respectively. A more promising power conversion efficiency (PCE) of 12% along with an open-circuit voltage (Voc) of 0.81 V, a short-circuit current density (Jsc) of 22.79 mA cm⁻² and a fill factor (FF) of 0.64 is obtained for D-Spiro-OMeTADnp devices. Despite the still notable fill factor (FF) and open-circuit voltage (Voc) losses compared to MoOx/Ag interfaces, this is among the highest power conversion efficiency (PCE) for inverted organic solar cells (OSCs) based on solution-processed hole transport layer (HTL) (Figure 5d and Table 5). The corresponding external quantum efficiency (EQE) spectra are presented in Figure 5b. The high short-circuit current density (Jsc) of D-Spiro-OMeTADnp devices benefits not only from the intrinsic better transparency of Spiro-OMeTAD, which reduces the parasitic absorption from the interface layer, but also from the interconnected mesoscopic 1D fiber dominated surface observed for the spiro-based nanoparticular hole transport layer (HTL). Different to D-P3HTnp and D-PTAAnp, which both form 0D mesoscopic structures (Figure 5e), Spiro-OMeTAD forms 1d needle like structures (Figure 5f). It is suggested that the interconnected 1D mesoscopic network forms 2d nanoporous grid that has better collection properties as compared to the non-interconnected 0d structures observed for D-P3HTnp and D-PTAAnp.

**Table 4. Photovoltaic parameters of PM6:Y6 OSCs.**

| | **Speed [mm s⁻¹]** | **Jsc [mA cm⁻²]** | **Voc [V]** | **FF [%]** | **PCE [%]** |
|---|---|---|---|---|---|
| D-Spiro-OMeTADnp-20% | 1 unannealed | 22.77 | 0.586 | 54 | 7.19 |
| | 5 unannealed | 21.34 | 0.692 | 59 | 8.75 |
| | 5 | 21.41 | 0.805 | 60 | 10.29 |
| D-Spiro-OMeTADnp-30% | 1 | 22.70 | 0.693 | 59 | 9.26 |
| | 5 | 21.26 | 0.822 | 62 | 10.81 |
| | 10 | 20.42 | 0.821 | 61 | 10.17 |
| D-Spiro-OMeTADnp-40% | 1 | 22.24 | 0.819 | 63 | 11.56 |
| | 5 | 19.73 | 0.836 | 66 | 10.94 |
| | 10 | 17.89 | 0.843 | 64 | 9.66 |
| D-P3HTnp-30% | 1 | 20.72 | 0.591 | 54 | 6.64 |
| | 5 | 20.31 | 0.680 | 57 | 7.93 |
| | 10 | 19.63 | 0.712 | 58 | 8.08 |
| | 30 | 16.46 | 0.819 | 62 | 8.40 |
| D-PTAAnp-30% | 1 | 21.69 | 0.674 | 56 | 8.16 |
| | 5 | 20.34 | 0.792 | 60 | 9.68 |
| | 10 | 18.84 | 0.823 | 61 | 9.40 |
| | 30 | 14.87 | 0.824 | 60 | 7.30 |

**Table 5. Reported PCEs for inverted OSCs based on solution-processed HTL.**

| Year | Active layer | HTL material | HTL solvent | PCE [%] |
|---|---|---|---|---|
| 2011 | P3HT:PCBM | sulfonic acid ring-substituted polyaniline | water with surfactant | 3.54 |
| 2013 | P3HT:PCBM | MoOx | IPA | 3.84 |
| 2017 | PCE-10:[60]PCBM | MoOx mixed PEDOT | water with alcohols | 7.40 |
| 2017 | PffBT4T-2OD:PC71B | PMA | nitromethane | 7.80 |
| 2020 | PBDBT-2F:IT4F | Cu-NiOx | IPA | 7.92 |
| 2021 | PTB7-PCBM | VOx-PEDOT:PSS | water with ethanol | 8.60 |
| 2021 | PTB7-Th:IEICO-4F | NiO | water with IPA | 11.23 |

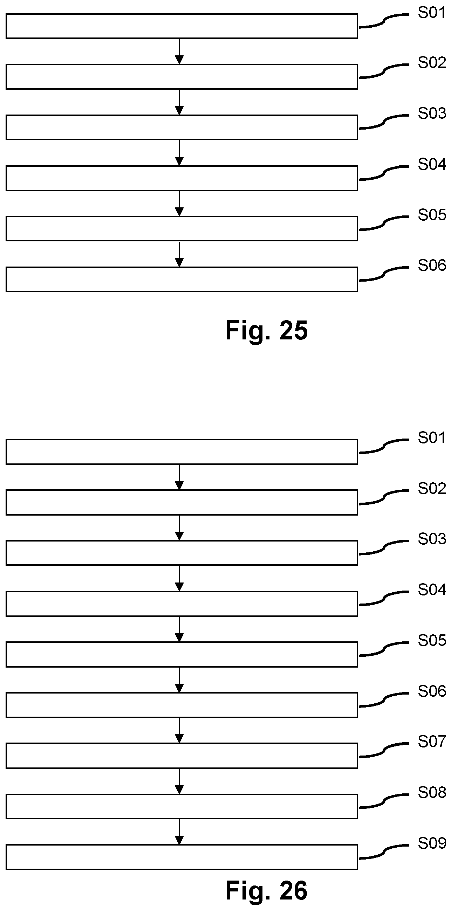

Fig. 25 shows a flow chart of an exemplary method for producing doped organic nanoparticles according to the invention. The following steps are preferably performed in succession.

In a step S01, a semiconducting polymer is dissolved in a solvent to form a solution. The semiconducting polymer is, for example, Spiro-OMeTAD. The full name of Spiro-OMeTAD is 2,2',7,7'-tetrakis(N,N'-di-p-methoxyphenylamine)-9,9'-spirobifluorene. The solvent is, for example, chloroform.

In a step S02, a Lewis acid dopant with a concentration of 10 wt% is added to the solution. The Lewis acid dopant is, for example,
tris(pentafluorophenyl)borane.

In a step S03, the solution is stirred during 20 hours at a temperature 20 °C.

In a step S04, a pre-assembled structure formed by strong interactions between the polymer-chains induced by doping is received.

In a step S05, the solution is injected into an alcohol based antisolvent.

In a step S06, a precipitation of doped organic nanoparticles is received as a colloidal dispersion, wherein the doped organic nanoparticles are formed by the pre-assembled structure encapsulating the dopant.

Fig. 26 shows a flow chart of an exemplary method for producing a functional layer according to the invention. The steps are preferably performed in succession.

The steps S01 to S06 correspond to the steps S01 to S06 from Fig. 25.

In a step S07, the solvent is evaporated.

In a step S08, the functional layer is formed by doctor blading of the dispersion in air.

In a step S09, the functional layer is annealed in a glovebox at a temperature of 100 °C for 8 min.

A novel solution-processed hole transport layer (HTL) for organic solar cells (OSCs) based on doped organic nanoparticles (D-NPs) is proposed together with a more general methodology for designing new interface materials, due to the high tailorability of the key properties (e. g. conductivity, work function). The application of these doped organic nanoparticles (D-NPs) as the hole transport layer (HTL) in inverted organic solar cells (OSCs) is demonstrated, exhibiting an ultrahigh efficiency in PM6:Y6 system. Accordingly, the inventive doped organic nanoparticles (D-NPs) are applicable to other printed electronics, thus, opening doors for a new class of interface materials to be implemented.

For the skilled person, it is clear that the above-mentioned embodiments of the devices, processes or process steps, can be combined with each other in any way and do not represent any limitation, especially in their design and combination.

## Claims

1. A method for producing doped organic nanoparticles, comprising the following steps, in particular in the following order:
a) dissolving a semiconducting polymer in a solvent to form a solution,
b) adding a dopant to the solution,
c) receiving a pre-assembled structure formed by strong interactions between the polymer-chains induced by doping,
d) injecting the solution into an antisolvent, preferably into an alcohol based antisolvent,
e) receiving a precipitation of doped organic nanoparticles as a dispersion, wherein the doped organic nanoparticles are formed by the pre-assembled structure encapsulating the dopant
f) evaporating the solvent.

2. A method for producing a functional layer for an organic semiconductor device, comprising the following steps, in particular in the following order:
a) dissolving a semiconducting polymer in a solvent to form a solution,
b) adding a dopant to the solution,
c) receiving a pre-assembled structure formed by strong interactions between the polymer-chains induced by doping,
d) injecting the solution into an antisolvent, preferably into an alcohol based antisolvent,
e) receiving a precipitation of doped organic nanoparticles as a dispersion, wherein the doped organic nanoparticles are formed by the pre-assembled structure encapsulating the dopant,
f) evaporating the solvent,
g) forming the functional layer.

3. The method according to claim 1 or 2, wherein the semiconducting polymer is selected from the group comprising P3AT, P3BT, P3HT, P3OT, PTAA, Spiro-OMeTAD, PBDB-T, PJ1, N2200, PolyTPD and combinations thereof, and/or
wherein the solvent is selected from the group comprising chloroform (CF), dichloromethane, tetrahydrofuran, and combinations thereof, and/or
wherein the dopant is selected from the group comprising Lewis acid dopant, F2TCNQ, F6TCNNQ, CN6-CP, piperazine, TBAOH and combinations thereof.

4. The method according to any one of the preceding claims, wherein the method comprises the following step, in particular between step b) and c):
h) stirring the solution during a time in a range of 2 to 48 hours, preferably in a range of 8 to 30 hours, more preferably in a range of 12 to 24 hours, most preferably in a range of 18 to 22 hours at a temperature in the range of 0 to 40 °C, preferably in the range of 15 to 25 °C, more preferably in the range of 18 to 22 °C.

5. The method according to any one of the preceding claims, wherein the antisolvent is selected from the group comprising isopropanol, ethanol, 3-hexanol, isobutanol, tert-butanol and combinations thereof.

6. The method according to any one of the preceding claims, wherein the functional layer is formed in step g) by doctor blading, spin coating, spray coating, ink-jet printing and/or screen-printing of the dispersion.

7. The method according to any one of the preceding claims, wherein the method comprises the following step, in particular after step g):
i) annealing of the functional layer,
wherein the annealing is preferably carried out at a temperature in the range of 50 to 130 °C, more preferably in the range of 80 to 110 °C, and wherein the annealing is preferably carried out during a time in the range of 20 s to 20 min, more preferably in the range of 2 to 10 min.

8. A functional layer of an organic semiconductor device, preferably produced by the method according to claim 2,
wherein the functional layer comprises (alcohol based) doped organic nanoparticles produced by means of a semiconducting polymer, a solvent, a dopant, and an antisolvent, preferably an alcohol based antisolvent.

9. The functional layer according to claim 8, wherein the doped organic nanoparticles have an average diameter in the range of 10 to 100 nm, preferably in the range of 20 to 70 nm, more preferably in the range of 40 to 60 nm.

10. The functional layer according to claim 8 or 9, wherein the functional layer is an electron or hole transport layer in a solar cell, in a light-emitting diode, a photodetector or an X-ray detector.

11. The functional layer according to claim 8 or 9, wherein the functional layer is provided in a printed electronic device, and/or in a thermoelectric device, and/or in artificial skin, and/or in an implant.

12. An organic semiconductor device comprising the functional layer according to any one of the claims 8 to 11.

13. The organic semiconductor device according to claim 12, wherein the organic semiconductor device is a solar cell, and wherein the functional layer is an electron or hole transport layer of the solar cell.

14. The organic semiconductor device according to claim 12, wherein the organic semiconductor device is a light-emitting diode, a photodetector or an X-ray detector, and wherein the functional layer is an electron or hole transport layer of the light-emitting diode, the photodetector or the X-ray detector, respectively.

15. The organic semiconductor device according to claim 12, wherein the organic semiconductor device is a printed electronic device, a thermoelectric device, artificial skin or an implant.
